# EUROPEAN PATENT SPECIFICATION

(11) **EP 3 979 426 B1**
(45) Date of publication and mention of the grant of the patent: **15.10.2025**
(21) Application number: 20199389.6
(22) Date of filing: 30.09.2020
(51) Int. Cl.: H01R 12/73, H01R 12/70, H01R 12/91, H05K 1/14, H01R 12/77, H01R 13/56, H05K 3/10, H05K 3/36

(54) **BRIDGE CONNECTOR ASSEMBLY**
BRÜCKENVERBINDERANORDNUNG
ENSEMBLE DE CONNECTEURS EN PONT

(43) Date of publication of application: 06.04.2022
(73) Proprietor: TE Connectivity Belgium BVBA, 8020 Oostkamp (BE); TE Connectivity Solutions GmbH, 8200 Schaffhausen (CH); TE Connectivity Svenska AB, 194 26 Upplands Vasby (SE)
(72) Inventor: DECROCK, Lieven, 8800 Roeselare (BE); ANDERSSON, Hans Magnus Emil, 177 71 Järfälla (SE); ANDREWS, JR., Howard Wallace, Hummelstown, PA Pennsylvania 17036 (US)
(74) Representative: Grünecker Patent- und Rechtsanwälte PartG mbB

(56) References cited:
- DE-A1- 3 705 751
- JP-A- H01 149 304
- KR-A- 20090 030 888
- US-A- 4 780 094
- US-A- 5 669 775
- US-A1- 2011 059 644
- US-A1- 2020 106 201

## Description

The invention relates to a bridge connector assembly.

Bridge connectors are known for creating a contact between two spaced apart electric components, such as printed circuit boards or the like. However, in modern applications the trend to minimise the space of an assembly prevails, such that obstacles like walls or posts are often arranged between the two components. Therefore, conventional bridge connectors, which are rather rigid, cannot be used in such applications when their path is being blocked by an obstacle. Furthermore, in order to decrease the manual workload and increase production efficiency, automated assembly of the bridge connector to the components is desired. Automatic manipulators, such as grippers, need to be able to handle the bridge connector assembly and push it into connection with the components.

US 2020/0106201 A1 concerns a board-to-board connector assembly for add-in cards that comprises two connectors and a plurality of cables electrically connecting the two connectors. Within each connector, an overmold material is provided to secure the wires.

US 5,669,775 A relates to an assembly for mounting components to flexible cables.

US 4,780,094 A relates to an extension cord of under-carpet flat cables that comprises a strip of insulated conductors located in a stiffly flexible sleeve-form shield strip mounted at opposite ends in rigid outlet supporting housings with the conductors terminated to leads of the outlets. The shield strip comprises metal and plastic strips that extend above and below the conductor strip. A further metal shield strip is located in the sleeve between the conductor strip and the plastic strip.

DE 37 05 751 A1 discloses a stress-reducing member for bendable flat cables, wherein the stress-reducing member is attached directly to the connector.

JP H01 149304 A concerns a flat cable attached to two connectors, wherein a handling feature is provided that allows for gripping the cable for inserting or removing the cable into or out of the corresponding connector.

KR 2009 0030888 A discloses a bridge connector having a first and a second socket into which a flat cable is inserted, which is fixed in its position and pressed against electrical contacts of the sockets by means of an actuator that is latched into each of the sockets.

Therefore, it is the objective of the invention to provide a flexible bridge connector assembly that is easy to handle.

In accordance with the present invention, the problem is solved by a bridge connector assembly comprising at least two connectors and at least one electric cable extending between the two connectors along a longitudinal axis of the at least one electric cable, the at least two connectors being arranged on the same side of the at least one electric cable in relation to the at least one electric cable and facing in a direction essentially perpendicular to the at least one electric cable. The bridge connector assembly further comprises at least one stiffening sleeve surrounding at least part of the at least one electric cable, wherein the at least one stiffening sleeve is a unitary monolithic component.

According to the inventive solution, the at least one electric cable provides flexibility and may be routed around the obstacles arranged between the at least two electric components. Therefore, the inventive bridge connector assembly increases the degree of freedom when installing an assembly comprising the at least two electric components being connected to one another via the bridge connector assembly. Furthermore, the rigidity of the electric cable may at least partly be increased by the at least one stiffening sleeve. The at least one stiffening sleeve restrains the movement of the electric cable in a controlled and predictable manner. Consequently, the flexibility and the handleability of the bridge connector assembly increases greatly allowing for an automated installation of the bridge connector assembly.

The invention can be further improved by the following features, which are independent from one another with regard to their respective technical effects and which can be combined arbitrarily.

For example, according to a first exemplary embodiment, the at least two connectors may be oriented towards the same direction relative to the at least one electric cable, particularly relative to the longitudinal axis of the electric cable. This may even further facilitate the automated assembly, as the forces for connecting the respective connectors with the corresponding electric components extend essentially parallel to one another, so that the installation can be accomplished in a single step.

The at least two connectors may preferably be angled connectors having an interface end and a cable end, the interface end being arranged at an angle to the cable end, particularly a 90° degree angle. The at least one electric cable may be inserted into the cable end along the longitudinal axis of the at least one electric cable and be terminated at a terminal of the connector, the terminal extending along the interface side.

According to an exemplary embodiment, the at least one electric cable may provide a data line between the at least two connectors. Alternatively, the at least one electric cable may be a power line connecting the at least two connectors. If both a data line and a power line run between the at least two connectors, at least two electric cables may be provided, one cable being a data line and the other cable being a power line. The at least two electric cables may be linked to one another, e.g. via a common insulation, or be separate and movable relative to one another. When the at least two electric cables are movable relative to one another, each cable may be routed a different way in order to avoid obstacles between the at least two components. In this case, each electric cable may be at least partially surrounded by a separate stiffening sleeve.

In accordance with a further advantageous embodiment, more than two connectors may be provided, each connector being connected with at least one other connector via at least one electric cable. Therefore, the bridge connector assembly may comprise a web-like structure. One connector may be connected to the remainder of the connectors. The electric cables coming from each connector may be bundled or merged at an end at which they may be connected to the one connector.

To further increase the handleability of the bridge connector assembly, the at least two electric cables may be at least partially surrounded by the same stiffening sleeve. Therefore, particularly in the region surrounded by the stiffening sleeve, the movement of the at least two electric cables may be restrained preventing unpredictable movement of the cables at said region.

The rigidity of the at least one stiffening sleeve may be high enough to not deform under its own weight or under a resistance force acting upon it during mating the connectors with the electric components. However, the at least one stiffening sleeve may still be flexible enough to compensate for tolerances.

The at least one electric cable may be a ribbon cable, particularly a flat flexible cable (FFC), allowing for easy termination of multiple cable leads of the at least one electric cable.

In order to prevent the at least one stiffening sleeve to slide relative to the at least one cable along the longitudinal axis of the at least one cable, the at least one stiffening sleeve may be rigidly attached to the at least one cable at least along said longitudinal axis. Therefore, the region of the at least one cable, which may be surrounded by the at least one stiffening sleeve, may be predetermined. By having a predetermined region of the at least one cable with increased stiffness, the predictability of the bridge connector assembly's movement may be further increased. Particularly in automated processes the predetermined region allows for a manipulation device to grip the bridge connector assembly by the at least one stiffening sleeve without having to check the relative position of the at least one stiffening sleeve along the longitudinal axis of the at least one cable first.

According to a further exemplary embodiment, the at least one stiffening sleeve may be spaced apart from at least one of the at least two connectors. Therefore, a section with increased flexibility is ensured by the part of the electric cable extending between the at least one stiffening sleeve and the respective connector. Consequently, bending the cable in said section is possible and allows the components, which are bridged via the bridge connector assembly to be moved relative to one another. This in tum allows for greater flexibility when mounting the assembly comprising the at least two components being bridged by the bridge connector assembly into a housing for example.

Preferably, the at least one stiffening sleeve may be spaced apart from each of the at least two connectors. Therefore, a flexible section may be provided between the at least one stiffening sleeve and each of the at least two connectors, the flexible section being more flexible than the immediate surroundings along the longitudinal axis of the at least one cable. The at least one stiffening sleeve may particularly be spaced apart equidistantly from at least two of the at least two connectors.

Alternatively, at least two stiffening sleeves may be provided each stiffening sleeve of the at least two stiffening sleeves being arranged adjoining to a corresponding connector of the at least two connectors, wherein the at least two stiffening sleeves may be spaced apart from one another along the longitudinal axis of the at least one cable. Therefore, the at least one stiffening sleeve may form a shell protecting or strengthening the termination of the cable in the respective connector. Therefore, the section of increased flexibility may be provided between the at least two stiffening sleeves, while the at least two stiffening sleeves may increase the surface area for gripping the respective connectors and pushing them into engagement with the respective component.

The handleability of the bridge connector assembly may be further increased when the at least one stiffening sleeve extends from one of the at least two connectors to the other of the at least two connectors. The at least one stiffening sleeve may particularly extend continuously from one of the at least two connectors to the other of the at least two connectors. Therefore, a single robot may grip the bridge connector at any point of the at least one stiffening sleeve. The force actuated from the robot to the at least one stiffening sleeve may be transferred to each of the at least two connectors via the at least one stiffening sleeve for pushing the connectors into engagement with the respective components.

At least one of the at least one stiffening sleeve may be rigidly attached to at least one of the at least two connectors. The connector may for example comprise a housing, which may be extended via the at least one stiffening sleeve, thereby increasing the surface area for a robot to grip the connector and actuate an insertion force on said connector. The at least one stiffening sleeve and the respective connector may be attached to one another by a form fit engagement, such as a latching engagement. Alternatively, the at least one stiffening sleeve may be moulded to the respective connector.

The at least one cable may be held at least partially loosely along a radial direction of the at least one cable within the at least one stiffening sleeve. Therefore, the at least one cable may be moved in the radial direction of the at least one cable independently to the at least one stiffening feature. However, it has proven to be more advantageous, when the at least one cable may be at least partially embedded in the at least one stiffening sleeve. Consequently, the at least one cable may be fixed firmly and deeply in the at least one surrounding stiffening sleeve, such that relative movement between the part of the cable being surrounded by the at least one stiffening sleeve and the at least one stiffening sleeve is prevented. Thus, the at least one stiffening sleeve may improve the mechanical stability of the bridge connector assembly and provide a means for controlling the resonance in applications with high vibrations.

The at least one stiffening sleeve is a unitary monolithic component allowing for easy and cost efficient production of the at least one stiffening sleeve particularly in large numbers.

The at least one stiffening feature may be electrically insulating, thereby further functioning as a protective insulation member. It may be formed of an insulating resin material, preferably by an injection moulding process. Preferably, the at least one cable may be routed in a predetermined fashion and subsequently overmoulded with the at least one stiffening feature. Thereby, the flexibility of the at least one cable may be utilised to circumvent obstacles in the path between the at least two components and then fixed in its predetermined routed state by the overmould.

If the at least one stiffening sleeve should be adapted to increase the electromagnetic interference protection of the bridge connector assembly, the at least one stiffening sleeve may be electrically conductive. The at least one stiffening sleeve may be a stamped metal sheet being bent over or around the at least one cable. Therefore, the at least one stiffening sleeve may be a stamped and formed harness.

Both an overmould with an insulating material, filled material or the forming of the stiffening sleeve from a stamped metal sheet may particularly be advantageous, as they allow the assembly of the at least one stiffening sleeve after assembly of the at least two connectors and the at least one electric cable. Consequently, such assemblies may be upgraded with the at least one stiffening sleeve for increasing the handleability and thereby enabling automated installation of the bridge connector assembly.

Especially if the electric cable is adapted to bridge larger distances, e.g. by having a larger length, it is advantageous, when the bridge connector assembly comprises at least one reinforcement plate, which abuts the electric cable. The at least one reinforcement plate may further increase the stiffness of the section of the electric cable at which it is arranged. It may be positioned along the longitudinal axis of the cable and may be arranged between the at least one cable and the at least one stiffening sleeve. The at least one stiffening sleeve may for example be moulded over both the at least one cable and the at least one reinforcement plate.

Preferably, the at least one reinforcement plate may be electrically conductive, so that the at least one reinforcement plate may further act as a shielding against electromagnetic interference.

For allowing handling of the bridge connector assembly by a robot, the at least one stiffening sleeve may comprise at least one manipulation feature for engaging the robot. Depending on the corresponding robot, the at least one manipulation feature may for example be realised as a planar outer surface adapted to be engaged by a suction gripper. Alternatively or additionally, at least one stiffening feature may be formed as holes on the outer surface for receiving pins of the robot or *vice versa.*

The at least one stiffening sleeve may preferably extend essentially parallel to the longitudinal axis of the electric cable and thus essentially perpendicular to the at least two connectors, particularly their interface side.

If more than one cable is provided, at least one stiffening sleeve may be formed as a bracket having at least two arms extending away from each other. Each arm of the at least two arms may be adapted to surround a corresponding cable, such that the bracket holds the cables apart from one another, creating a gap between the cables. Consequently, the bracket may not only prevent entanglement of the cables but also routes the cables to circumvent obstacles.

The invention further relates to an assembly comprising at least two electric components, the at least two electric components being spaced apart from one another and being connected to one another by the bridge connector assembly according to any of the aforementioned embodiments.

Preferably, the electric components being bridged by the bridge connector assembly may be adapted to be moved relative to one another. Therefore, the installation of the assembly in a housing for example may be further facilitated. This may be achieved by having the at least one electric cable remain flexible at least in sections without the at least one stiffening sleeve.

In the following, the exemplary embodiments of the angled connector according to the invention are explained in greater detail with reference to the accompanying drawings.

In the figures, the same reference numerals are used for elements which correspond to one another in terms of their function and/or structure.

According to the description of the various aspects and embodiments, elements shown in the drawings can be omitted if the technical effects of these elements are not needed for a particular application, and *vice versa*: i.e. elements that are not shown or described with reference to the figures but are described above can be added if the technical effect of those particular elements is advantageous in a specific application.

In the figures:
- Fig. 1: shows a schematic perspective view of a first exemplary embodiment of the inventive bridge connector assembly;
- Fig. 2: shows a schematic cut view of the first exemplary embodiment shown in Fig.1 cut along the line A-A;
- Fig. 3: shows a schematic perspective view of the second exemplary embodiment of the inventive bridge connector assembly; and
- Fig. 4: shows a schematic perspective view of a third exemplary embodiment of the inventive bridge connector assembly.

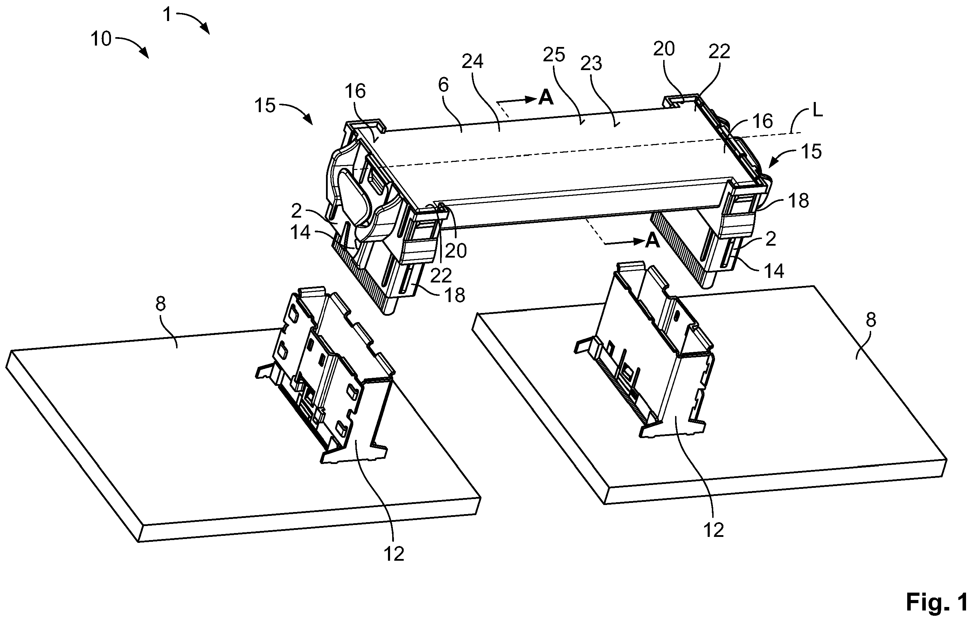

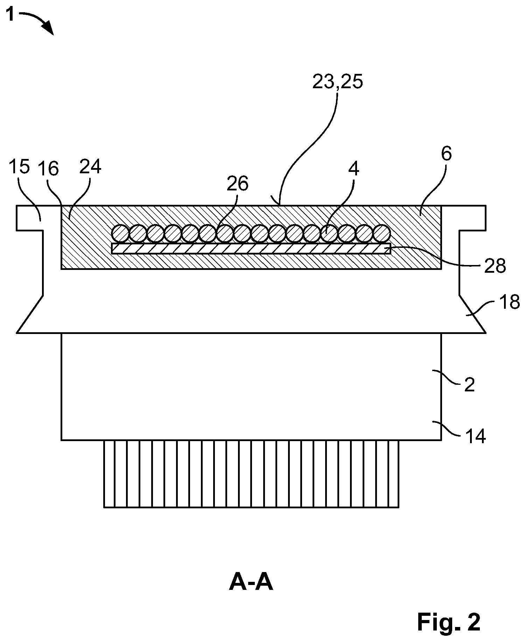

With reference to Figs. 1 and 2 a first exemplary embodiment of a bridge connector assembly 1 according to the invention is further elucidated.

The bridge connector assembly 1 comprises at least two connectors 2 and at least one electric cable 4 extending between the at least two connectors 2 along a longitudinal axis L of the at least one electric cable 4. The at least two connectors 2 may be arranged on the same side of the at least one electric cable 4 in relation to the at least one electric cable 4 and facing in a direction essentially perpendicular to the at least one electric cable 4. In other words, the at least two connectors 2 may extend essentially perpendicular to the at least one electric cable 4, in particular, essentially perpendicular to the at least one electric cable's longitudinal axis L, in the same direction in relation to the at least one electric cable 4, particularly its longitudinal axis L.

The bridge connector assembly 1 further comprises at least one stiffening sleeve 6 surrounding at least part of the at least one electric cable 4.

The bridge connector assembly 1 can be used to connect at least two electric components 8, which are arranged spaced apart from one another. Thereby, forming an assembly 10 wherein each of the connectors 2 is mated with the corresponding component 8. In the figures, assembly 10 is only shown in an unmated state.

The at least two electric components 8 may be two subsystems on a circuit board, or two circuit boards, particularly printed circuit boards, having mating headers 12 mounted on a surface thereof. Each mating header 12 may be adapted to receive an interface end 14 of the corresponding connector 2 for electrically coupling the component 8 with the respective connector 2.

To facilitate the manufacturing of the bridge connector assembly 1, particularly the termination of the at least one cable 4 to the at least two connectors 2, the at least two connectors 2 may preferably be angled connectors 15, having a cable end 16 arranged at an angle relative to the interface end 14. The angled connector 15, may preferably be a 90° angled connector. Thus, the at least one electric cable 4 may be inserted into the angled connector 15 along its longitudinal axis L. The at least two connectors 2 may for example comprise an interface terminal, such as a printed circuit board, extending along the interface end 14 , wherein the at least one electric cable 4 may abut the interface terminal and be soldered to it.

The at least two connectors 2 may be identical to one another and may comprise a housing 18. The housing 18 may particularly be formed of an ally insulating material and may be open at the cable end 16. Preferably, the housing 18 may comprise an undercut 20 at the cable end 16 adapted to receive a shoulder 22 of the at least one stiffening sleeve 6, protruding essentially perpendicular to the longitudinal axis L of the at least one cable 4 and a longitudinal axis of the respective connector's 2 interface end 14. Consequently, the at least one stiffening sleeve 6 and the housing 18 may be engaged to one another in a form fitting manner, securing the at least one stiffening sleeve 6 and the housing 18 to one another.

In accordance with the first embodiment, one stiffening sleeve 6 may be provided, which extends continuously from one connector 2 to the other connector 2. Consequently, the entire electric cable 4 may be surrounded by the stiffening sleeve 6. Therefore, the rigidity of the bridge connector assembly 1 along the entire length of the cable 4 may be increased, thereby greatly increasing the handleability of the bridge connector assembly 1. Unpredictable movement due to the flexibility of the cable 4 is avoided, such that a robot arm may be easily configured to grip the bridge connector assembly 1 and mount it to the components 8. The robot arm (not shown) may grip the bridge connector assembly 1 at any point of the stiffening sleeve 6, whereby the force acting on the stiffening sleeve 6 by the robot arm may be transmitted to the connectors 2 via the rigid connection between the stiffening sleeve 6 and the connectors 2.

To allow the robot arm to grip the bridge connector assembly 1 at the stiffening sleeve 6, the stiffening sleeve 6 may be provided with at least one manipulation feature 23, such as a smooth outer surface 25 for allowing the engagement to the robot arms via suction cups.

Preferably, the stiffening sleeve 6 may be rigid such that it is not deformed by its own weight or the insertion force.

As can be seen in Fig. 1, the stiffening sleeve 6 is a unitary monolithic component 24. It may be formed of an electrically insulating material such as an insulating resin. Advantageously, the at least one stiffening sleeve 6 may be overmoulded to the electric cable 4 and the connectors 2 further enhancing the rigid bond between the stiffening sleeve 6 on one hand and the electric cable 4 and the connectors 2 on the other hand.

Hence, the electric cable 4 may be embedded in the stiffening sleeve 6, in which case the stiffening sleeve 6 not only acts a protective shell protecting the electric cable 4, but also acts as a vibration dampening feature by fixedly holding the electric cable 4.

Alternatively, to the stiffening sleeve 6 being formed from an electrically insulating material, the stiffening sleeve may be electrically conductive. It may be formed as a stamped and bent metal sheet, which may thus also act as a shielding, protecting the cable 4 from electromagnetic interference from outside the sleeve 6 or vice versa.

The at least one electric cable 4 may preferably be a ribbon cable, particularly a flat flexible cable (FFC) 26, having multiple cable leads arranged side by side essentially parallel to the longitudinal axis L of the cable 4, as is shown in Fig. 2. However, ribbon cables may be limited in their high-speed performance. Therefore, particularly for high-speed applications of 25 Gbps and beyond the cable 4 may preferably be single differential pair cables.

In order to further increase the rigidity of the bridge connector assembly 1, particularly for large cable lengths, a reinforcement plate 28 may be provided abutting the cable 4 (see Fig. 2). The reinforcement plate 28 may extend essentially parallel to the longitudinal axis of the cable 4 and be arranged between the stiffening sleeve 6 and the cable 4. Preferably, the reinforcement plate 28 may be overmoulded together with the cable 4 when forming the stiffening sleeve 6.

Preferably, the at least one reinforcement plate 28 may be electrically conductive thereby acting as a further shielding component increasing the shielding performance of the bridge connector assembly 1 against electromagnetic interference. The electromagnetic interference can also be improved by using a conductive filler in the molded component.

According to another advantageous aspect, the stiffening sleeve 6 may be mounted to the electric cable 4 after bending the electric cable 4, so that it extends along a predetermined path. Consequently, the flexibility of the electric cable 4 may be utilised in order to avoid obstacles between the two components 8.

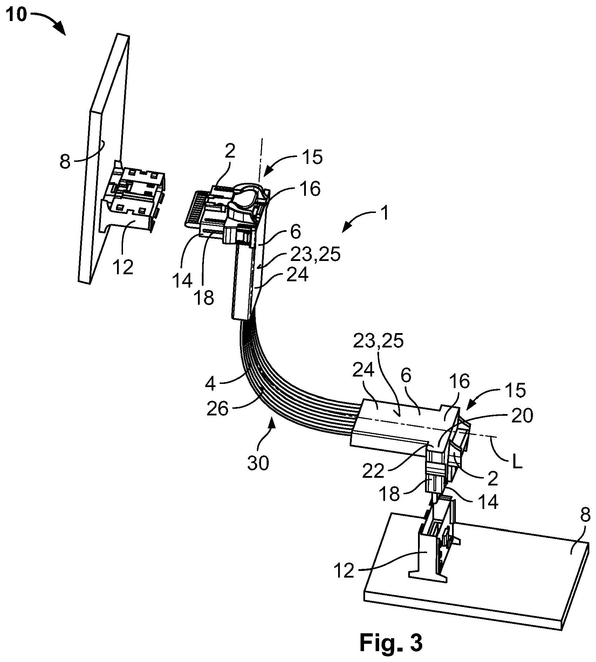

A secondary exemplary embodiment of the bridge connector assembly 1 is now described with reference to Fig. 3. For the sake of brevity, only the differences to the first embodiment will be discussed in more detail.

Contrary to the first embodiment, the second embodiment comprises two stiffening sleeves 6 being spaced apart from one another along the longitudinal axis L. Therefore, a section 30 of the electric cable 4 is laid bare from the stiffening sleeve 6, said section having thus an increased flexibility compared to the remainder of the bridge connector assembly 1.

Consequently, it is possible to tilt the components 8 and the connectors 2 relative to one another as is shown in Fig. 3. Furthermore, said flexible section 30 may also be used to circumvent obstacles after mounting of the stiffening sleeves 6.

The stiffening sleeves 6 may each be rigidly connected to a corresponding connector 2 and extend essentially parallel to the longitudinal axis L of the electric cable 4. Hence, each stiffening sleeve 6 may form an extension of the respective connector's 2 housing 18 further protecting the termination between the connector 2 and the cable 4.

Furthermore, each stiffening sleeve 6 forms a point of attachment for a robot arm to enable automatic mounting of the bridge connector assembly 1 to the components 8.

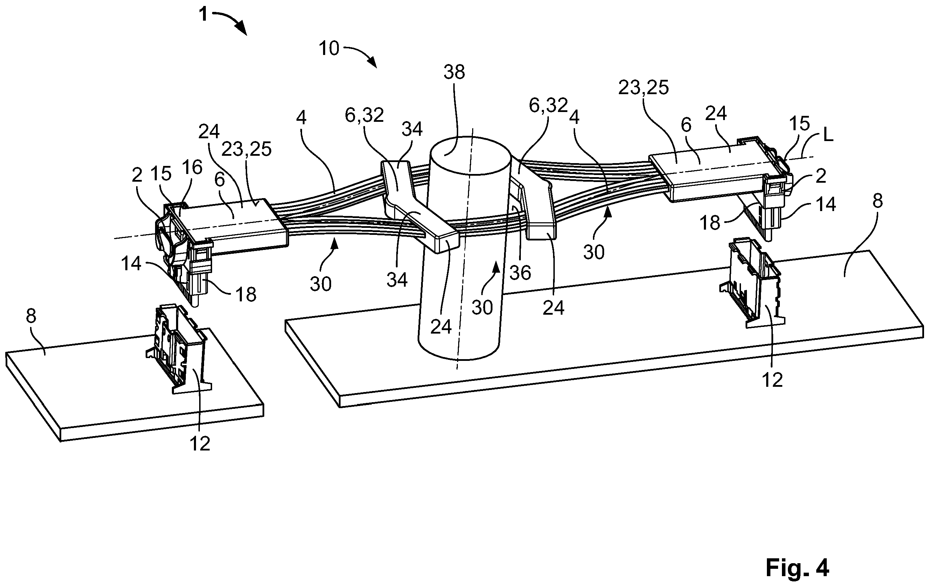

In Fig. 4, yet another advantageous embodiment of the bridge connector assembly 1 is shown.

In this third exemplary embodiment, the bridge connector assembly 1 comprises two electric cables 4 arranged next to one another.

As in the second embodiment, the bridge connector assembly 1, according to the third embodiment, may comprise a stiffening sleeve 6 extending from each connector 6 and being spaced apart from one another. Said stiffening sleeves 6 being connected to the corresponding connector 2 may surround both cables 4 simultaneously within a single cavity.

Further stiffening sleeves 6 may be provided at intervals along the longitudinal axes L of the electric cables 4. Therefore, multiple flexible sections 30 may be provided, each section extending between two adjacent stiffening sleeves 6 along the longitudinal axis L of the electric cable 4.

Each cable may comprise a separate stiffening sleeve 6. However, as is shown in Fig. 4, it may be more advantageous if a stiffening sleeve 6 is formed as a bracket 32 having two arms 34 extending away from one another, each arm 34 having a cavity in which a respective cable 4 of the two cables 4 is received, or arm 34 might be overmolded to the two cables 4, creating the wanted structure. Therefore, the bracket 32 spreads the two cables away from one another forming a gap 36 between them. Preferably, two brackets 32 may be provided opposite one another for stabilising the width of the gap 36 between both brackets 32.

Each bracket 32 may be rigidly attached to the electric cables 4 so that the bracket 32 is held immovable along the longitudinal axis L of the electric cables 4 relative to the electric cables 4. Therefore, the gap 36 may be easily configured according to predetermined application surroundings.

However, if gap 36 should be adjustable, e.g. in order to configure the length of gap 36 along the longitudinal axis L of cable 4, brackets 32 may be held slidably relative to electric cables 4.

As can be seen in Fig. 4, cables 4 may be rerouted with the brackets 32 in order to circumvent an obstacle 38 which may be arranged between the corresponding mating headers 12 of the components 8.

### REFERENCE NUMERALS

- 1: bridge connector assembly
- 2: connector
- 4: electric cable
- 6: stiffening sleeve
- 8: electric component
- 10: assembly
- 12: mating header
- 14: interface end
- 15: angled connector
- 16: cable end
- 18: housing
- 20: undercut
- 22: shoulder
- 23: manipulation feature
- 24: monolithic component
- 25: outer surface
- 26: flat flexible cable
- 28: reinforcement plate
- 30: flexible section
- 32: bracket
- 34: arm
- 36: gap
- 38: obstacle

- L: longitudinal axis

## Claims

1. A bridge connector assembly (1) comprising at least two connectors (2) and at least one electric cable (4) extending between the at least two connectors (2) along a longitudinal axis (L) of the at least one electric cable (4), the at least two connectors (2) being arranged on the same side of the at least one electric cable (4) in relation to the at least one electric cable (4) and facing in a direction perpendicular to the at least one electric cable (4), **characterized in that** the bridge connector assembly (1) further comprises at least one stiffening sleeve (6) surrounding at least part of the at least one electric cable (4), wherein the at least one stiffening sleeve (6) is a unitary monolithic component (24).

2. The bridge connector assembly (1) according to claim 1, wherein the at least one stiffening sleeve (6) is rigidly attached to the at least one electric cable (4).

3. The bridge connector assembly (1) according to claim 1 or 2, wherein the at least one stiffening sleeve (6) is spaced apart from at least one of the at least two connectors (2).

4. The bridge connector assembly (1) according to claim 1 or 2, wherein the at least one stiffening sleeve (6) extends from one of the at least two connectors (2) to the other of the at least two connectors (2).

5. The bridge connector assembly (1) according to any one of claims 1 to 4, wherein the at least one stiffening sleeve (6) is rigidly attached to at least one of the at least two connectors (2).

6. The bridge connector assembly (1) according to any one of claims 1 to 5, wherein the at least one cable is embedded in the at least one stiffening sleeve (6).

7. The bridge connector assembly (1) according to any one of claims 1 to 6, wherein the at least one stiffening sleeve (6) is electrically insulating.

8. The bridge connector assembly (1) according to any one of claims 1 to 6, wherein the at least one stiffening sleeve (6) is electrically conductive.

9. The bridge connector assembly (1) according to any one of claims 1 to 8, wherein the bridge connector assembly (1) further comprises at least one reinforcement plate (28), which abuts the at least one electric cable (4).

10. The bridge connector assembly (1) according to any one of claims 1 to 9, wherein the at least one stiffening sleeve (6) comprises at least one manipulation feature (23).

11. The bridge connector assembly (1) according to any one of claims 1 to 10, wherein the at least one stiffening sleeve (6) extends parallel to the longitudinal axis of the at least one electric cable (4).

12. The bridge connector assembly (1) according to any one of claims 1 to 11, wherein the bridge connector assembly (1) comprises at least two electric cables (4), the at least two electric cables (4) being at least partially surrounded by the at least one stiffening sleeve (6).

13. An assembly (10) comprising at least two separate electric components (8) spaced apart from one another and a bridge connector assembly (1) according to any one of claims 1 to 12, the at least two electric components (8) being connected to one another by the bridge connector assembly (1).

14. The assembly (10) according to claim 13, wherein the electric components (8) being connected to one another by the bridge connector assembly (1) are movable relative to one another.

## Patentansprüche

1. Eine Brückenverbinder-Baugruppe (1), die mindestens zwei Verbinder (2) und mindestens ein elektrisches Kabel (4) aufweist, das sich zwischen den mindestens zwei Verbindern (2) entlang einer Längsachse (L) des mindestens einen elektrischen Kabels (4) erstreckt, wobei die mindestens zwei Verbinder (2) auf derselben Seite des mindestens einen elektrischen Kabels (4) in Bezug auf das mindestens eine elektrische Kabel angeordnet sind (4) auf derselben Seite des mindestens einen Kabels (4) angeordnet sind und in einer Richtung senkrecht zu dem mindestens einen Kabel (4) weisen, **dadurch gekennzeichnet, dass**
die Brückenverbinder-Baugruppe (1) ferner mindestens eine Versteifungshülse (6) aufweist, die mindestens einen Teil des mindestens einen Kabels (4) umgibt, wobei die mindestens eine Versteifungshülse (6) ein einstückiges monolithisches Bauteil (24) ist.

2. Die Brückenverbinder-Baugruppe (1) gemäß Anspruch 1, wobei die mindestens eine Versteifungshülse (6) starr an dem mindestens einen elektrischen Kabel (4) befestigt ist.

3. Die Brückenverbinder-Baugruppe (1) gemäß Anspruch 1 oder 2, wobei die mindestens eine Versteifungshülse (6) von mindestens einem der mindestens zwei Verbinder (2) beabstandet ist.

4. Die Brückenverbinder-Baugruppe (1) gemäß Anspruch 1 oder 2, wobei sich die mindestens eine Versteifungshülse (6) von einem der mindestens zwei Verbinder (2) zum anderen der mindestens zwei Verbinder (2) erstreckt.

5. Die Brückenverbinder-Baugruppe (1) gemäß einem der Ansprüche 1 bis 4, wobei die mindestens eine Versteifungshülse (6) starr an mindestens einem der mindestens zwei Verbinder (2) befestigt ist.

6. Die Brückenverbinder-Baugruppe (1) gemäß einem der Ansprüche 1 bis 5, wobei das mindestens eine Kabel in die mindestens eine Versteifungshülse (6) eingebettet ist.

7. Die Brückenverbinder-Baugruppe (1) gemäß einem der Ansprüche 1 bis 6, wobei die mindestens eine Versteifungshülse (6) elektrisch isolierend ist.

8. Die Brückenverbinder-Baugruppe (1) gemäß einem der Ansprüche 1 bis 6, wobei die mindestens eine Versteifungshülse (6) elektrisch leitfähig ist.

9. Die Brückenverbinder-Baugruppe (1) nach einem der Ansprüche 1 bis 8, wobei die Brückenverbinder-Baugruppe (1)
weiterhin mindestens eine Verstärkungsplatte (28) aufweist, die an das mindestens eine elektrische Kabel (4) angrenzt.

10. Die Brückenverbinder-Baugruppe (1) gemäß einem der Ansprüche 1 bis 9, wobei die mindestens eine Versteifungshülse (6) mindestens ein Manipulationsmerkmal (23) aufweist.

11. Die Brückenverbinder-Baugruppe (1) gemäß einem der Ansprüche 1 bis 10, wobei die mindestens eine Versteifungshülse (6) sich parallel zur Längsachse des mindestens einen Kabels (4) erstreckt.

12. Die Brückenverbinder-Baugruppe (1) gemäß einem der Ansprüche 1 bis 11, wobei die Brückenverbinder-Baugruppe (1) mindestens zwei elektrische Kabel (4) aufweist, wobei die mindestens zwei elektrischen Kabel (4) mindestens teilweise von der mindestens einen Versteifungshülse (6) umgeben sind.

13. Eine Baugruppe (10) aufweisend mindestens zwei voneinander beabstandete trennbare elektrische Komponenten (8) und eine Brückenverbinder-Baugruppe (1) gemäß einem der Ansprüche 1 bis 12, wobei die mindestens zwei elektrischen Komponenten (8) durch die Brückenverbinder-Baugruppe (1) miteinander verbunden sind.

14. Die Baugruppe (10) gemäß Anspruch 13, wobei die elektrischen Bauteile (8), die durch die Brückenverbinder-Baugruppe (1) miteinander verbunden sind, relativ zueinander beweglich sind.

## Revendications

1. Ensemble de connecteurs en pont (1) comprenant au moins deux connecteurs (2) et au moins un câble électrique (4) s'étendant entre lesdits au moins deux connecteurs (2) le long d'un axe longitudinal (L) dudit au moins un câble électrique (4), lesdits au moins deux connecteurs (2) étant agencés du même côté dudit au moins un câble électrique (4) par rapport audit au moins un câble électrique (4) et étant orientés dans une direction perpendiculaire audit au moins un câble électrique (4), **caractérisé en ce que** l'ensemble de connecteurs en pont (1) comprend en outre au moins une gaine de raidissement (6) entourant au moins une partie dudit au moins un câble électrique (4), dans lequel ladite au moins une gaine de raidissement (6) est un composant monolithique unitaire (24).

2. Ensemble de connecteurs en pont (1) selon la revendication 1, dans lequel ladite au moins une gaine de raidissement (6) est fixée de manière rigide audit au moins un câble électrique (4).

3. Ensemble de connecteurs en pont (1) selon la revendication 1 ou 2, dans lequel ladite au moins une gaine de raidissement (6) est espacée d'au moins un desdits au moins deux connecteurs (2).

4. Ensemble de connecteurs en pont (1) selon la revendication 1 ou 2, dans lequel ladite au moins une gaine de raidissement (6) s'étend depuis l'un desdits au moins deux connecteurs (2) vers l'autre desdits au moins deux connecteurs (2).

5. Ensemble de connecteurs en pont (1) selon l'une quelconque des revendications 1 à 4, dans lequel ladite au moins une gaine de raidissement (6) est fixée de manière rigide à au moins un desdits au moins deux connecteurs (2).

6. Ensemble de connecteurs en pont (1) selon l'une quelconque des revendications 1 à 5, dans lequel ledit au moins un câble est intégré dans ladite au moins une gaine de raidissement (6).

7. Ensemble de connecteurs en pont (1) selon l'une quelconque des revendications 1 à 6, dans lequel ladite au moins une gaine de raidissement (6) est électriquement isolante.

8. Ensemble de connecteurs en pont (1) selon l'une quelconque des revendications 1 à 6, dans lequel ladite au moins une gaine de raidissement (6) est électriquement conductrice.

9. Ensemble de connecteurs en pont (1) selon l'une quelconque des revendications 1 à 8, dans lequel l'ensemble de connecteurs en pont (1) comprend en outre au moins une plaque de renforcement (28), qui jouxte ledit au moins un câble électrique (4).

10. Ensemble de connecteurs en pont (1) selon l'une quelconque des revendications 1 à 9, dans lequel ladite au moins une gaine de raidissement (6) comprend au moins une caractéristique de manipulation (23).

11. Ensemble de connecteurs en pont (1) selon l'une quelconque des revendications 1 à 10, dans lequel ladite au moins une gaine de raidissement (6) s'étend parallèlement à l'axe longitudinal dudit au moins un câble électrique (4).

12. Ensemble de connecteurs en pont (1) selon l'une quelconque des revendications 1 à 11, dans lequel l'ensemble de connecteurs en pont (1) comprend au moins deux câbles électriques (4), lesdits au moins deux câbles électriques (4) étant au moins partiellement entourés par ladite au moins une gaine de raidissement (6).

13. Ensemble (10) comprenant au moins deux composants électriques (8) séparés, espacés l'un de l'autre, et un ensemble de connecteurs en pont (1) selon l'une quelconque des revendications 1 à 12, lesdits au moins deux composants électriques (8) étant reliés l'un à l'autre par l'ensemble de connecteurs en pont (1).

14. Ensemble (10) selon la revendication 13, dans lequel les composants électriques (8) qui sont reliés l'un à l'autre par l'ensemble de connecteurs en pont (1) sont mobiles l'un par rapport à l'autre.
